**Europäisches Patentamt**

**European Patent Office**

**Office européen des brevets**

(11) Veröffentlichungsnummer: **0 608 697 A1**

# EUROPÄISCHE PATENTANMELDUNG

(21) Anmeldenummer: **94100282.6**

(22) Anmeldetag: **11.01.94**

(51) Int. Cl.5: **H03F 1/32**, H03C 1/06,
H04L 27/36

(30) Priorität: **29.01.93 DE 4302456**

(43) Veröffentlichungstag der Anmeldung:
**03.08.94 Patentblatt 94/31**

(84) Benannte Vertragsstaaten:
**CH DE FR GB LI**

(71) Anmelder: **TELEFUNKEN Sendertechnik GmbH
Sickingenstrasse 20-28
D-10553 Berlin(DE)**

(72) Erfinder: **Weber, Klaus, Dipl.-Ing.
Grüntaler Strasse 8
D-13357 Berlin(DE)**
Erfinder: **Eberhardt, Fred, Dipl.-Ing.
Damkitzstrasse 14
D-13503 Berlin(DE)**

(74) Vertreter: **Salhoff, Roland, Dipl.-Ing.
Deutsche Aerospace AG,
SedanStrasse 10
D-89077 Ulm (DE)**

(54) **Modulationsverfahren und -schaltung für HF-Signale.**

㊗ 2.1 Aufgabe der Erfindung ist es ein Modulationsverfahren und eine dafür geeignete Schaltung mit geringen Anforderungen an die Bauelementetoleranzen und den Schaltungsabgleich bei gleichzeitiger Abdeckung eines großen Frequenzbereiches des HF-Signales zu schaffen.

2.2 Diese Aufgabe wird erfindungsgemäß dadurch gelöst, daß die In-Phase- und Quadratur-Komponente des NF-Modulationssignales vorverzerrt werden, daß diese Vorverzerrung von einem Korrekturdatensatz gesteuert ist, der in einer verfahrensgemäßen Modulationsschaltung resistent abgespeichert ist und daß dieser Korrekturdatensatz durch einen Abgleich der Modulationsschaltung ermittelt wird, wobei der Abgleich so erfolgt, daß das Gesamtausgangssignal ein optimales Ergebnis bezüglich der angestrebten Betrags- und Phasenmodulation aufweist.

2.3 Die Erfindung findet Anwendung bei einem Modulationsverfahren zur Erzeugung eines in Betrag und Phase modulierten HF-Signales mittels einer Bildung von zwei zueinander phasenverschobenen Trägerfrequenzschwingungen, einer Aufspaltung des NF-Modulationssignales in eine In-Phase und Quadratur-Komponente, Amplitudenmodulation je einer der HF-Komponenten mit der In-Phase- bzw. der Quadratur-Komponente des NF- Modulationssignales und einer Zusammenfügung der so amplitudenmodulierten HF-Komponenten zu einem Gesamtausgangssignal.

Fig. 1

Die Erfindung bezieht sich auf ein Modulationsverfahren und eine -schaltung zur Erzeugung eines in Betrag und Phase modulierten HF-Signales gemäß den Oberbegriffen der Ansprüche 1 und 6 sowie auf eine Phasenmodulation gemaß den Oberbegriffen der Ansprüche 2 und 7.

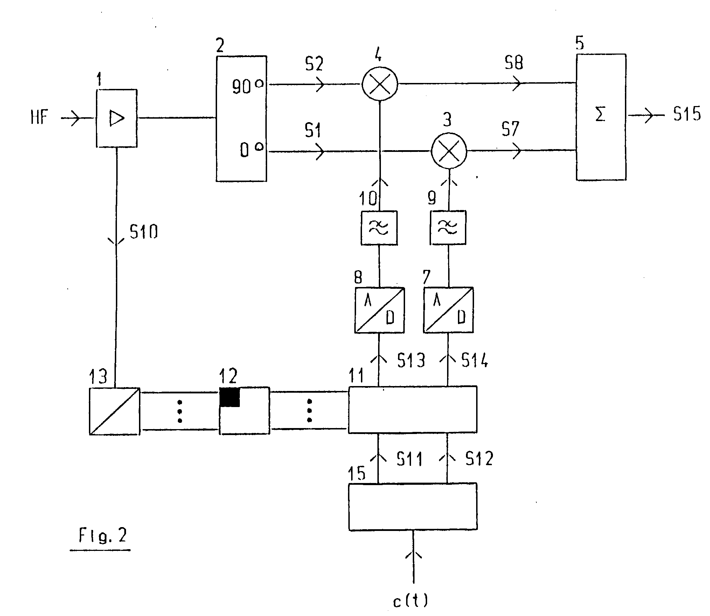

Den in Betrag und Phase modulierten HF-Signalen sind bekannterweise die Einseitenbandsignale zuzurechnen. Zur Erzeugung von Einseitenbandsignalen wird in der Literatur neben anderen Verfahren auf die "Phasenmethode" hingewiesen, bei der zwei um 90 Grad gegeneinander phasenverschobene Trägerfrequenzschwingungen mit der In-Phase- bzw. der Quadratur-Komponente des NF-Modulationssignales amplitudenmoduliert werden. Die so modulierten Komponenten des HF-Trägers werden auf ein Summationsglied gegeben, in dem durch Kompensation von Spektralkomponenten die Seitenbandunterdrückung erfolgt (Single-Sideband-Systems & Circuits, Sabin u. Schoenike, MC Graw-Hill Book Company 1988, S. 30, Fig. 2. 17). Um eine ausreichende Unterdrückung des unerwünschten Seitenbandes und des Trägers zu erzielen, müssen die 90 Grad-Phasenverschiebungen des HF- und des NF-Signales und eine möglichst hohe Symmetrie der Mischer eingehalten werden. Ferner ist eine kapazitive überkopplung in den Mischern zu vermeiden. Es ist bekannt, daß die Bedingungen in herkömmlichen Modulationsschaltungen, die nach der "Phasenmethode" arbeiten, nur mit großem Schaltungs- und Abgleichaufwand erfüllbar sind, vor allem wenn es gilt, die Modulation in einem großen Bereich der Trägerfrequenz auszuführen.

Die Phasen- und Betragsbedingungen der NF-Komponenten lassen sich mit genügender Genauigkeit und Stabilität einstellen, wenn im NF-Zweig der Modulationsschaltung digitale Signalverarbeitungsbausteine verwendet werden. Damit sind aber noch nicht die Phasen- und Betragsfehler unterdrückt, die durch die HF-Bauteile der Schaltung entstehen.

Aufgabe der Erfindung ist es ein Modulationsverfahren und eine dafür geeignete Schaltung mit geringen Anforderungen an die Bauelementetoleranzen und den Schaltungsabgleich bei gleichzeitiger Abdeckung eines großen Frequenzbereiches des HF-Signales zu schaffen.

Diese Aufgabe wird erfindungsgemäß durch die in den Kennzeichen der Ansprüche 1 und 6 angegebenen Merkmale gelöst. In Anspruch 11 ist eine Anwendung der Erfindung für ein Modulationsverfahren angegeben, das abweichend von dem Gegenstand der vorangehenden Ansprüche zwei quaternäre Digitalsignale für die Trägermodulationen benutzt. Anspruch 12 betrifft eine Schaltung zur Durchführung dieses Verfahrens. Weiterbildungen der Erfindung sind in den Unteransprüchen angegeben.

Das erfindungsgemäße Verfahren bietet den Vorteil, daß mit handelsüblichen Schaltungsbauelementen eine hohe Modulationsgüte erreichbar ist. Das Verfahren läßt sich mit analogen und digitalen Schaltungen durchführen. In dem Verfahren werden mit einer erfindungsgemäßen Vorverzerrung der NF-Komponenten fehlerhafte Abweichungen in den HF-Komponeten kompensiert. Diese NF-Vorverzerrung läßt sich einfacher und genauer als eine Korrektur ausführen, die direkt auf Bauelemente des HF-Zweiges einwirkt. Auch läßt diese NF-Vorverzerrung bei digitaler Quadratur des NF-Signales eine vorteilhafte Software-Vorverzerrung zu, indem rechnerisch auf die Digitaldaten der NF-Komponenten eingewirkt wird. Das erfindungsgemäße Verfahren ist nicht auf die Erzeugung von Einseitenbandsignalen beschränkt und kann auch bei der Erzeugung anderer in Betrag und Phase modulierter HF-Signale, die auf der "Phasenmethode" basiert, und auf eine entsprechend ausgeführte "reine" Phasenmodulation Anwendung finden.

Anhand der Zeichnung werden Ausführungsbeispiele der Erfindung näher erläutert.

Fig. 1    zeigt als Blockschaltbild eine Einseitenband-Modulationsschaltung und

Fig. 2    das Blockschaltbild einer 16-QAM-Modulationsschaltung mit einem digitalen NF-Signal.

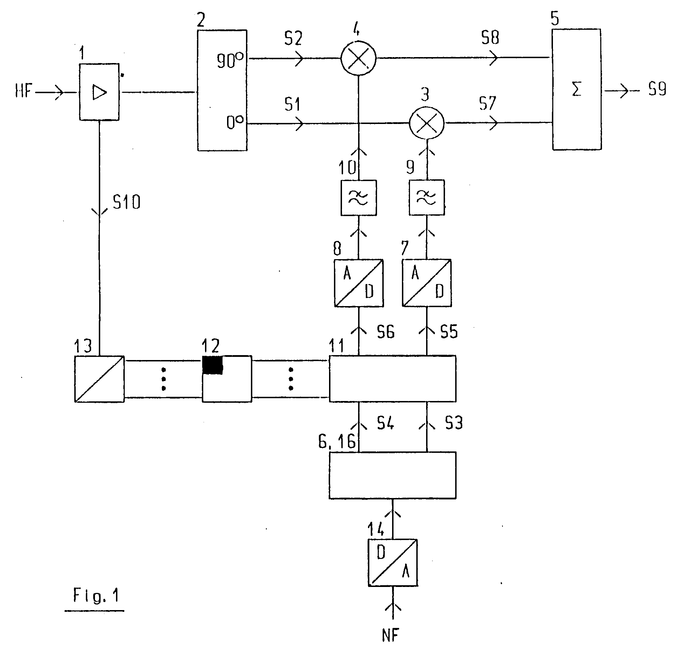

Die in Fig. 1 gezeigte Modulationsschaltung ist durch eine digitale Signalverarbeitung im NF-Zweig gekennzeichnet. Grundsätzlich läßt sich das erfindunsgemäße Verfahren auch in Schaltungen mit einem analogen NF-Zweig realisieren. Die Schaltung besteht aus einem Eingangsverstärker 1, einem Phasendrehglied 2, zwei Mischern 3 und 4, einem Summationsglied 5, einem NF-Quadraturglied 6, zwei D/A-Wandlern 7 und 8, zwei Tiefpässen 9 und 10, einem Korrekturglied 11, einem Datenspeicher 12, einem Speichersteuerglied 13 und einem A/D-Wandler 14.

In der Schaltung wird das HF-Eingangsignal nach einer Verstärkung im Eingangsverstärker 1 in dem nachgeschalteten Phasendrehglied 2 in zwei um 90 Grad zueinander phasenverschobene HF-Trägersignale S1, S2 umgeformt. Das als Referenzsignal dienende HF-Signal S1 am Null-Grad-Ausgang des Phasendrehgliedes 2 wird zum Zwecke der Amplitudenmodulation auf den Mischer 3 gegeben. Ebenso wird das um 90 Grad gegenüber dem Referenzsignal phasenverschobene HF-Eingangsignal S2 auf den anderen Mischer 4 gegeben. An den Ausgängen der Mischer 3, 4 stehen modulierte Trägersignale S7, S8 an, die auf das Summationsglied 5 gegeben werden.

Die Modulationssignale für die Mischer 3, 4 sind, entsprechend der bekannten "Phasenmethode", aus der In-Phasen- und Quadratur-Komponente des zu übertragenden NF-Modulationssignales gebildet. In dem gezeigten Ausführungsbeispiel ist als NF-Quadraturglied 6 ein digitaler Hilbert-Transformator eingesetzt, an dessen beiden Ausgängen die NF-Komponenten S3, S4 in digitaler Form anstehen. In einem dem Hilbert-Transformator nachgeschalteten Korrekturglied 11 werden die Digitaldaten der NF-Komponenten S3, S4 mit Korrekturfaktoren rechnerisch beaufschlagt. Diese Faktoren wirken vorverzerrend auf die Phase, Amplitude und den Gleichanteil der NF-Komponenten S3, S4 ein. An den Ausgängen des Korrekturgliedes 11 stehen vorverzerrte NF-Komponenten S5, S6 an, die nach einer Digital-Analog-Wandlung in den D/A-Wandlern 7, 8 und nach einer Ausfilterung von störenden Spektralanteilen, die durch die digitale Signalverarbeitung erzeugt werden, in den Tiefpässen 9, 10 den Mischern 3, 4 als Modulationssignale zugeführt sind.

Die Korrekturfaktoren für die Vorverzerrung der NF-Komponenten S3, S4 werden dem Korrekturglied 11 aus einem Datenspeicher 12 zur Verfügung gestellt. Das Speichersteuerglied 13 aktiviert dazu in Abhängigkeit von der Frequenz der HF-Eingangssignalprobe S10, die aus dem Eingangsverstärker 1 abgezweigt ist, in dem Datenspeicher 12 einen bestimmten Korrekturdatensatz, der für diese Trägerfrequenz eine optimale Vorverzerrung der NF-Komponenten S3, S4 ermöglicht. Die Anzahl der abgespeicherten Korrekturdatensätze korreliert mit einer bestimmten Anzahl von Trägerfrequenzbereichen, die auf den Einsatzfall der Modulationsschaltung abgestimmt ist.

Mit der vorangehend beschriebenen Modulationsschaltung wird das erfindungsgemäße Verfahren so ausgeführt, daß die Korrekturdatensätze für die Vorverzerrung der NF-Komponenten S3, S4 bei einem einmaligen Abgleich der Schaltung mittels eines Spektralanalysators ermittelt werden. Hierbei werden beispielsweise für einen bestimmten Trägerfrequenzbereich die einzelnen Korrekturdaten eines Datensatzes derart abgeglichen, daß das zu unterdrückende Seitenband im Gesamtausgangssignal S9 maximal gedämpft ist, oder eine andere gewünschte Phasen- und Betragsmodulation optimal eintritt. Die so ermittelten Korrekturdatensätze werden in Speicherelementen des Datenspeichers 12, die den jeweiligen Trägerfrequenzbereichen zugeordnet sind, für eine betriebsmäßige Verwendung resistent gespeichert.

Bei einer Modulationsschaltung mit einem digitalisierten NF-Zweig bietet sich die Automatisierung dieses Abgleiches mittels eines rechnergesteuerten Meßplatzes an, wobei die ermittelten Korrekturwerte sofort in das entsprechende Speicherelement des Datenspeichers 12 geschrieben werden.

Die Korrekturberechnung in dem Korrekturglied 11 erfolgt mittels der nachfolgenden Matrixoperation:

$$\begin{vmatrix} S5 \\ S6 \end{vmatrix} = \begin{vmatrix} A1 * \cos(p1) & A1 * \sin(p1) \\ A2 * \sin(p2) & A2 * \cos(p2) \end{vmatrix} * \begin{vmatrix} S3 \\ S4 \end{vmatrix} + \begin{vmatrix} C1 \\ C2 \end{vmatrix}$$

Diese Matrixoperation erzeugt korrigierte NF-Komponenten S5, S6, die über die Mischer 3, 4 auf die modulierten Trägersignale S7, S8 wie folgt einwirken:

Der Korrekturparameter A1 (A2) bestimmt die Amplitude des Signales S5 (S6) und damit die Amplitude des Signales S7 (S8) und gleicht damit einen Amplitudenfehler dieses Signales aus.

Der Korrekturparameter p1 (p2) wirkt auf die Phasenlage des Signales S5 (S6) und damit auf die Phasenlage des Signales S7 (S8) und gleicht damit einen Phasenfehler dieses Signales aus.

Der Korrekturparameter C1 (C2) bestimmt den Gleichanteil des Signales S5 (S6) und damit die Größe der Trägerfrequenzamplitude des Signales S7 (S8) und gleicht damit eine Unsymmetrie des Mischers 3 (4) aus und kompensiert ferner eine kapazitive Überkopplung im Mischer 4 (3).

Das erfindungsgemäße Verfahren ist nicht allein auf die Aufbereitung von Einseitenbandsignalen beschränkt. Allgemein kann ein in Betrag und Phase moduliertes Signal durch den nachfolgenden Ausdruck beschrieben werden:

$$s(t) = a(t) * \cos(wt + phi(t))$$

$a(t)$ = Verlauf der Hüllkurve (Betrag)
$phi(t)$ = zeitlicher Verlauf des Phasenwinkels
$w_T$ = Trägerkreisfrequenz

Mittels des Additionstheorems für cos-Funktionen kann dieser Ausdruck in die folgende Form umgewandelt werden (siehe auch F. Kühne, Modulationssysteme mit Sinusträgern, AEU, Band 25 (1971), Heft 3, Seite 117 ff)

$$s(t) = s_c(t) * \cos(w_T*t) - s_s(t) * \sin(w_T*t)$$

$s_c(t)$ = kophasale Komponente (In-Phase-Komponente)

$s_s(t)$ = Quadratur-Komponente

Daraus ergibt sich, daß jedes in Betrag und Phase modulierte Signal durch seine In-Phase- und Quadratur-Komponente beschreibbar ist und somit das erfindungsgemäße Verfahren allgemein auf diese Modulationsart anwendbar ist.

Es sind darüber hinaus aber auch Anwendungen in Modulationsverfahren möglich, in denen für die Erzeugung von in Betrag und in Phase modulierten Signalen als Modulationssignale für den 0-Grad- und den 90-Grad-Träger andere Signale als eine In-Phase- und Quadratur-Komponente verwendet werden.

Dazu ist zum Beispiel die Erzeugung eines 16-QAM Modulationssignales zu rechnen. Bei diesem in Fig. 2 dargestellten digitalen Modulationsverfahren werden 16 in Betrag und Phase voneinander zu unterscheidende Signalzustände eines binären Datensignales c(t) erzeugt. Zwei um 90-Grad zueinander versetzte Trägersignale S1 und S2 werden in ihren Amplituden mit zwei quaternären Signalen S11 und S12 moduliert, die in einem Signalwandler 15 als Parallelsignale aus dem binären Datensignal c(t) abgeleitet sind. (Rudolph Mäusl, Digitale Modulationsverfahren, Hüthig Verlag, Heidelberg, 1985, Seiten 238 und 239, insbesondere Bild 3.53). Erfindungsgemäß lassen sich die quaternären Signale S11 und S12 in einem Korrekturglied 11 vorverzerren, um so an einem Summationsglied 5 aus den amplitudenmodulierten HF-Komponenten (Träger) S7 und S8 optimal modulierte Signalzustände zu erhalten, die zusammen das 16-QAM-Modulationssignal bilden.

Ebenfalls ist das erfindungsgemäße Verfahren auf eine Phasenmodulation allein anwendbar, ohne daß gleichzeitig eine Amplitudenmodulation des phasenmodulierten Signales vorliegt. Diese Anwendungsmöglichkeit beruht darauf, daß sich ein nur in der Phase moduliertes Singal durch den nachfolgenden komplexen Zeigerausdruck beschreiben läßt:

$$s(t) = Re\ (exp(j(w^*t + phi(t)))$$

Re = Realteil

w = Kreisfrequenz

phi(t) = zeitlicher Verlauf des Phasenwinkels

Mit mathematischen Umformungen läßt sich der voranstehende Ausdruck wie folgt schreiben:

$$s(t) = Re\ (exp(jwt) * exp(jphi(t)))$$
$$= cos(wt) * cos(phi(t)) - sin(wt) * sin(phi(t))$$

Zur Anwendung des erfindungsgemäßen Verfahrens ist entsprechend dem voranstehenden Ausdruck die die Phasenmodulation bestimmende Winkelfunktion phi(t) in einem Signalprozessor 16, der das NF-Quadraturglied 6 in der in Fig. 1 beschriebenen Schaltung ersetzt, in eine Sinus- und Cosinus-Funktion umzuformen (sin(phi(t)), cos(phi(t))). Diese Funktionssignale dienen dann als Modulationssignale der HF-Komponenten S1 und S2 (cos(wt), sin(wt)). Erfindungsgemäß lassen sich die Funktionssignale mit dem digitalen Korrekturglied 11 vorverzerren, um am Ausgang der Schaltung ein optimal phasenmoduliertes Signal zu erhalten. Entsprechend dem voranstehenden Ausdruck ist dazu in Abweichung zu Fig. 1 das Summationsglied 5 durch ein Subtraktionsglied zu ersetzen und zu beachten, daß die niederfrequente Nachricht NF bei der "reinen" Phasenmodulation durch die Winkelfunktion phi(t) bestimmt ist und daß die NF-Komponenten S3, S4 die Sinus- und Cosinus-Funktionen mit dem Argument phi(t) enthalten. Alle anderen Schaltungsmerkmale entsprechen der in Fig. 1 gezeigten Schaltung.

Diese Art der Modulation kann Anwendung beim AM-Stereo, bei dem das Summensignal des rechten und des linken Kanals in der Hüllkurve und das Differenzsignal in einer unterlagerten Phasenmodulation mitübertragen wird, und bei der Frequenzmodulation im UKW-Rundfunk finden.

## Patentansprüche

1. Modulationsverfahren zur Erzeugung eines in Betrag und Phase modulierten HF-Signales mittels einer Bildung von zwei zueinander phasenverschobenen Trägerfrequenzschwingungen, einer Aufspaltung des NF-Modulationssignales in eine In-Phase- und Quadratur-Komponente, Amplitudenmodulation je einer der HF-Komponenten mit der In-Phase- bzw. der Quadratur-Komponente des NF-Modulationssignales und einer Zusammenfügung der so amplitudenmodulierten HF-Komponenten zu einem Gesamtausgangssignal, dadurch gekennzeichnet, daß die In-Phase- und die Quadratur-Komponente des NF-Modulationssignales vorverzerrt werden, daß diese Vorverzerrung von einem Korrekturdatensatz gesteuert ist, der in einer verfahrensgemäßen Modulationsschaltung resistent abgespeichert ist und daß dieser Korrekturdatensatz durch einen Abgleich der Modulationsschaltung ermittelt wird, wobei der Abgleich so erfolgt, daß das Gesamtausgangssignal ein optimales Ergebnis bezüglich der angestrebten Betrags- und Phasenmodulation aufweist.

2. Modulationsverfahren zur Erzeugung eines phasenmodulierten HF-Signales mittels einer Bildung von zwei zueinander phasenverschobenen Trägerfrequenzschwingungen, einer Amplitudenmodulation je einer der HF-Komponenten mit einer Komponente des NF-Modulationssignales und einer Zusammenfügung der so amplitudenmodulierten HF-Komponenten zu einem Gesamtausgangssignal, dadurch gekennzeichnet, daß eine Komponente des NF-Modualtionssignales ein Sinus- und die andere Komponente ein Cosinus-Funktionssignal ist, daß die Funktionssignale das Argument phi(t) aufweisen, welches dem NF-Modulationssignal (NF) entspricht, daß diese Sinus- und Cosinus-Funktionen vorverzerrt werden, daß diese Vorverzerrung von einem Korrekturdatensatz gesteuert ist, der in einer verfahrensgemäßen Modulationsschaltung resistent abgespeichert ist und daß dieser Korrekturdatensatz durch einen Abgleich der Modulationsschaltung ermittelt wird, wobei der Abgleich so erfolgt, daß das Gesamtausgangssignal ein optimales Ergebnis bezüglich der angestrebten Phasenmodulation aufweist.

3. Modulationsverfahren nach Anspruch 1 oder 2, dadurch gekennzeichnet, daß durch mehrmaligen Abgleich der Modulationsschaltung mehrere Korrekturdatensätze in Abhängigkeit von der Frequenz des HF-Eingangssignales ermittelt und in der Schaltung resistent abgespeichert werden.

4. Modulationsverfahren nach einem der Ansprüche 1 bis 3, dadurch gekennzeichnet, daß die Ermittlung des Korrekturdatensatzes mittels eines Spektralanalysators erfolgt, mit dem die Modulationsqualität gemessen wird.

5. Modulationsverfahren nach einem der Ansprüche 1 bis 4, dadurch gekennzeichnet, daß der Abgleich an einem automatischen Meßplatz erfolgt mit dem die ermittelten Korrekturdatensätze sofort in digitale Speicherelemente der Modulationsschaltung geschrieben werden.

6. Modulationsschaltung zur Erzeugung eines in Betrag und Phase modulierten HF-Signales mit einem Phasendrehglied zur Bildung von zwei zueinander phasenverschobenen Trägerfrequenzschwingungen, zwei dem Phasendrehglied nachgeschalteten Mischern zur Amplitudenmodulation der HF-Komponenten, einem den Mischern nachgeschalteten Summationsglied zur Zusammenfügung der amplitudenmodulierten HF-Komponenten, einem NF-Quadraturglied zur Aufspaltung des NF-Modulationssignales in eine In-Phase- und Quadratur-Komponente, dadurch gekennzeichnet, daß dem NF-Quadraturglied (6) ein Korrekturglied (11) nachgeschaltet ist, das entsprechend einem abgespeicherten Korrekturdatensatz, auf die NF-Komponenten (S3, S4) so einwirkt, daß schaltungsbedingte Phasen- und Betragsfehler an den Signalen des HF-Zweiges unterdrückt werden, daß der Korrekturdatensatz in der Modulationsschaltung in einem Datenspeicher (12) resistent festgehalten ist und daß die vorverzerrten NF-Komponenten (S5, S6) den Mischern (3, 4) des HF-Zweiges als Modulationssignale zugeführt werden.

7. Modulationsschaltung zur Erzeugung eines phasenmodulierten HF-Signales mit einem Phasendrehglied zur Bildung von zwei zueinander phasenverschobenen Trägerfrequenzschwingungen, zwei dem Phasendrehglied nachgeschalteten Mischern zur Amplitudenmodulation der HF-Komponenten, einem den Mischern nachgeschalteten Summationsglied zur Zusammenfügung der amplitudenmodulierten HF-Komponenten, einem NF-Baustein zur Aufspaltung des NF-Modulationssignales in zwei NF-Komponenten, dadurch gekennzeichnet, daß die NF-Komponenten (S3, S4) in einem Signalprozessor (16) als Sinus- und Cosinus-Funktionen mit dem Argument des Phasenwinkels phi(t) gebildet sind, welches dem NF-Modulationssignal (NF) entspricht, daß dem Signalprozessor (16) ein Korrekturglied (11) nachgeschaltet ist, das entsprechend einem abgespeicherten Korrekturdatensatz, auf die NF-Komponenten (S3, S4) so einwirkt, daß schaltungsbedingte Phasen- und Betragsfehler an den Signalen des HF-Zweiges unterdrückt werden, daß der Korrekturdatensatz in der Modulationsschaltung in einem Datenspeicher (12) resistent festgehalten ist und daß die vorverzerrten NF-Komponenten (S5, S6) den Mischern (3, 4) des HF-Zweiges als Modulationssignale zugeführt sind.

8. Modulationsschaltung nach Anspruch 6 oder 7, dadurch gekennzeichnet, daß der Datenspeicher (12) mehrere Korrekturdatensätze enthält, die in Abhängigkeit von der jeweils zu modulierenden Trägerfrequenz mit einem Speichersteuerglied (13) für das Korrekturglied (11) aktiviert werden.

9. Modulationsschaltung nach Anspruch 6, dadurch gekennzeichnet, daß das NF-Quadraturglied (6) als digitaler Hilbert-Transformator ausgeführt ist.

10. Modulationsschaltung nach einem der Ansprüche 6 bis 9, dadurch gekennzeichnet, daß das Korrekturglied (11) mit digitalen Signalprozessoren aufgebaut ist.

11. Verfahren zur Erzeugung eines 16-QAM-Modulationssignales mittels einer Bildung von zwei um 90-Grad zueinander phasenverschobenen Trägerfrequenzschwingungen, einer Aufspaltung des binären Datensignales in zwei parallele quaternäre Signale, Amplitudenmodulation je einer der HF-Komponenten mit einem der quaternären Signale und einer Zusammenfügung der so amplitudenmodulierten HF-Komponenten zu einem Gesamtausgangssignal, das einen der 16 Signalzustände des 16-QAM-Signales bildet, dadurch gekennzeichnet, daß die quaternären Signale vorverzerrt werden, daß diese Vorverzerrung von einem Korrekturdatensatz gesteuert ist, der in einer verfahrensgemäßen Modulationsschaltung resistent abgespeichert ist und daß dieser Korrekturdatensatz durch einen Abgleich der Modulationsschaltung ermittelt wird, wobei der Ableich so erfolgt, daß das Gesamtausgangssignal ein optimales Ergebnis bezüglich der angestrebten Betrags- und Phasenmodulation aufweist.

12. Modulationsschaltung zur Erzeugung eines 16-QAM-Signales mit einem Phasendrehglied zur Erzeugung von zwei um 90-Grad zueinander phasenverschobenen Trägerfrequenzschwingungen, zwei dem Phasendrehglied nachgeschalteten Mischern zur Amplitudenmodulation der HF-Komponenten, einem den Mischern nachgeschalteten Summationsglied zur Zusammenfügung der amplitudenmodulierten Komponenten, einem Signalwandler zur Erzeugung von zwei parallelen quaternären Signalen aus einem binären Datensignal c(t), dadurch gekennzeichnet, daß dem Signalwandler (15) ein Korrekturglied (11) nachgeschaltet ist, das entsprechend einem abgespeicherten Korrekturdatensatz auf die quaternären Signale (S11, S12) so einwirkt, daß schaltungsbedingte Phasen- und Betragsfehler an den Signalen des HF-Zweiges unterdrückt werden, daß der Korrekturdatensatz in der Modulationsschaltung in einem Datenspeicher (12) resistent festgehalten ist, daß die vorverzerrten quaternären Signale (S13, S14) den Mischern (3, 4) des HF-Zweiges als Modulationssignale zugeführt werden und daß die in den Mischern (3, 4) modulierten Trägersignale (S7, S8) auf das nachgeschaltete Summationsglied (5) gegeben sind, in dem abhängig von den quaternären Signalen (S11, S12) die 16 Signalzustände (S15) des 16-QAM-Signals gebildet werden.

Fig. 1

EP 0 608 697 A1

Fig. 2

EP 0 608 697 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| X | EP-A-0 131 725 (M. HORN) <br> * Seite 13, Zeile 30 - Seite 16, Zeile 30; Ansprüche 18-23; Abbildung 8 * <br> --- | 1-12 | H03F1/32 <br> H03C1/06 <br> H04L27/36 |
| A | FREQUENZ, <br> Bd.45, Nr.1, Januar 1991, BERLIN, DE <br> Seiten 10 - 15, XP000224366 <br> F.J. HAGMANS 'ENTWICKLUNG DIGITAL MODULIERTER HF-SENDER MIT HILFE NUMERISCHER SPEKTRALANALYSE' <br> * Zusammenfassung; Abbildung 3 * <br> --- | 4 | |
| A | GB-A-2 173 074 (NEC CORPORATION) <br><br> * Seite 7, Zeile 99 - Seite 8, Zeile 120; Abbildungen 18,19 * <br> --- | 1,2,6,7, 11 | |
| A | EP-A-0 441 110 (TELEFONAKTIEBOLAGET L M ERICSSON) <br> * Zusammenfassung; Abbildungen 2,5,6 * <br> ----- | 1,2,6,7, 11 | |

RECHERCHIERTE SACHGEBIETE (Int.Cl.5)

H03F
H03C
H04L

Der vorliegende Recherchenbericht wurde für alle Patentansprüche erstellt

| Recherchenort | Abschlußdatum der Recherche | Prüfer |
|---|---|---|
| DEN HAAG | 3. Mai 1994 | Dhondt, I |

EPO FORM 1503 03.82 (P04C03)